# EUROPEAN PATENT APPLICATION

(11) **EP 4 307 023 A1**
(43) Date of publication of application: **17.01.2024**
(21) Application number: 22184172.9
(22) Date of filing: 11.07.2022
(51) Int. Cl.: G02B 6/42, H01L 21/56, H01L 23/16, H01L 23/31, H01L 25/16

(54) **PACKAGE HAVING COMPONENT CARRIER AND EMBEDDED OPTICAL AND ELECTRIC CHIPS WITH HORIZONTAL SIGNAL PATH IN BETWEEN**

(71) Applicant: AT & S Austria Technologie & Systemtechnik Aktiengesellschaft, 8700 Leoben-Hinterberg (AT)
(72) Inventor: Jörg, Tanja, 8700 Leoben (AT); Schlaffer, Erich, 8642 St. Lorenzen (AT)
(74) Representative: Dilg, Haeusler, Schindelmann Patentanwaltsgesellschaft mbH

(57) **Abstract**

A package (100), wherein the package (100) comprises a component carrier (102) comprising at least one electrically conductive layer structure (104) and/or at least one electrically insulating layer structure (106), and an optical chip (108) and an electric chip (110) being functionally coupled with each other and being embedded side-by-side in the component carrier (102) so that a signal path (112) between the optical chip (108) and the electric chip (110) is within a horizontal plane.

## Description

### Field of the Invention

The invention relates to a package and to a method of manufacturing a package.

### Technological Background

In the context of growing product functionalities of component carriers equipped with one or more components and increasing miniaturization of such components as well as a rising number of components to be connected to the component carriers such as printed circuit boards, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

US 2021/0066269 discloses a semiconductor package which includes a first redistribution layer structure, a photonic integrated circuit, an electronic integrated circuit, a waveguide and a memory. The photonic integrated circuit is disposed over and electrically connected to the first redistribution layer structure, and includes an optical transceiver and an optical coupler. The electronic integrated circuit is disposed over and electrically connected to the first redistribution layer structure. The waveguide is optically coupled to the optical coupler. The memory is electrically connected to the electronic integrated circuit.

Conventional approaches of forming a package which includes an optical chip and an electric chip have a high complexity and may suffer from signal distortion.

### Summary of the Invention

There may be a need to form a compact electrooptical package with high signal integrity.

According to an exemplary embodiment of the invention, a package is provided which comprises a component carrier comprising at least one electrically conductive layer structure and/or at least one electrically insulating layer structure, and an optical chip and an electric chip being functionally coupled with each other and being embedded side-by-side in the component carrier (preferably in a surface region of the component carrier) so that a signal path between the optical chip and the electric chip is within a horizontal plane.

According to another exemplary embodiment of the invention, a method of manufacturing a package is provided, wherein the method comprises providing a component carrier comprising at least one electrically conductive layer structure and/or at least one electrically insulating layer structure, functionally coupling an optical chip and an electric chip with each other, and embedding the optical chip and the electric chip side-by-side in the component carrier (preferably in a surface region of the component carrier) so that a signal path between the optical chip and the electric chip is within a horizontal plane.

In the context of the present application, the term "package" may particularly denote a device having one more components (such as a semiconductor die) mounted on a support structure and being electrically connected in the package.

In the context of the present application, the term "component carrier" may particularly denote any support structure which is capable of accommodating, directly or indirectly, one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, and an IC (integrated circuit) substrate. A component carrier may also be a hybrid board combining different ones of the above-mentioned types of component carriers.

In the context of the present application, the term "layer structure" may particularly denote a continuous layer, a patterned layer or a plurality of nonconsecutive islands within a common plane.

In the context of the present application, the term "chip" may particularly denote a member for instance fulfilling an electronic and/or an optical task. For instance, the chip may be an active component such as a semiconductor chip comprising a semiconductor material, in particular as a primary or basic material. The semiconductor material may for instance be a type IV semiconductor such as silicon or germanium, or may be a type III-V semiconductor material such as gallium arsenide. In particular, the chip may be a naked die or a molded die. At least one integrated circuit element may be monolithically integrated in such a chip.

In the context of the present application, the term "optical chip" may particularly denote a chip having an optical functionality. In particular, such an optical chip may be a chip configured for receiving an optical signal, and more particularly for converting the received optical signal into an electric signal by an electrooptical converter (such as a photodiode). The optical chip may also have processing capability for processing an optical signal and/or an electric signal to or from which the optical signal can be derived by the optical chip. The optical chip may be an electro-optical chip, in particular providing an optical functionality of an electro-optical system. In particular, the optical chip may also have an integrated semiconductor laser diode and/or an amplifier. Hence, examples of integrated circuit elements of an optical chip may be a photodiode and/or a laser diode. For example, integrated group III-V devices may be implemented in the optical chip, for example at least one laser, at least one amplifier and/or at least one photodiode.

In the context of the present application, the term "electric chip" may particularly denote a chip having an electric functionality. For example, the electric chip may be configured for processing an electric signal, in particular received from an optical chip. It is also possible that the electric chip comprises a drive functionality, in particular for driving an optical chip. The electric chip may be an electro-optical chip, in particular providing an electric functionality of an electro-optical system. In particular, the electric chip may have amplifying functionality, for instance provided by one or more transimpedance amplifiers (TIAs). When embodied as a transmitter, the electric chip may function as interface between a modulator and its driver. When embodied as receiver, the electric chip may function as interface between the photodiode and an assigned TIA.

In the context of the present application, the term "functionally coupled chips" may particularly denote that the optical chip and the electric chip may be interconnected for functionally cooperating with each other. For instance, signal transmission (in particular electric signal transmission and/or optical signal transmission) may be enabled between the optical chip and the electric chip. For instance, one of said chips may drive the other one. It is also possible that one of the chips processes signals provided by the other one.

In the context of the present application, the term "embedded chips" may particularly denote fully embedded or only partially embedded. In a fully embedded embodiment, the entire vertical spatial range between upper end and lower end of the respective chip is located inside of the component carrier. In a partially embedded embodiment, only part of a vertical spatial range between upper end and lower end of the respective chip is located inside of the component carrier, for instance the chip may protrude upwardly and/or downwardly beyond the component carrier. In one embodiment, the upper end of the at least partially embedded respective chip may be in alignment with an upper main surface of the component carrier and/or the lower end of the respective chip may be in alignment with a lower main surface of the component carrier. In another embodiment, the upper end of the respective chip may be located below an upper main surface of the component carrier and/or the lower end of the at least partially embedded respective chip may be located above a lower main surface of the component carrier. However, it is also possible that an upper end portion of the respective chip protrudes vertically beyond an upper main surface of the component carrier and/or that a lower end portion of the respective chip protrudes vertically below an upper main surface of the component carrier.

In the context of the present application, the term "chips arranged side-by-side" may particularly denote that the electric chip and the optical chip are arranged laterally with respect to each other. In particular, the electric chip and the optical chip may share at least one common horizontal plane extending through both the electric chip and the optical chip. In an embodiment, an entire vertical extension range of the optical chip coincides with an entire vertical extension range of the electric chip. In such an embodiment, both the electric chip and the optical chip may have the same thickness and may have lower main surfaces in alignment with each other and upper main surfaces in alignment with each other. In another embodiment, only part of a vertical extension range of the optical chip coincides with a vertical extension range of the electric chip. In such an embodiment, it is for instance possible that the thickness of the electric chip and the optical chip are different, and that only upper main surfaces or lower main surfaces of the electric chip and the optical chip are in alignment with each other.

Each chip as well as the component carrier may comprise two opposing main surfaces. The main surfaces may form the two largest surface areas of the chip or the component carrier. The main surfaces are connected by circumferential side walls. The thickness of a chip or component carrier is defined by the distance between the two opposing main surfaces. The main surfaces may comprise functional sections, such as conductive traces or conductive interconnections with further elements.

In the context of the present application, the term "a signal path between the optical chip and the electric chip is within a horizontal plane" may particularly denote that signal propagation between optical chip and electric chip may occur horizontally rather than vertically. Substantially the entire signal propagation between optical chip and electric chip may thus be within a horizontal plane of the package. In particular, no electrically conductive through connections (such as stacked vias or metal pillars) and/or optical vertical through connections (for instance vertical optical fibers or fiber sections) will thus contribute to the signal transfer between optical chip and electric chip. For example, an electric redistribution layer, at least part of which connecting the optical chip with the electric chip, may extend horizontally over one or only some thin horizontal films. Optionally, the signal path between the optical chip and the electric chip within the horizontal plane may be also laterally extended along a further path portion from the electric chip away from the optical chip and/or from the optical chip away from the electric chip.

According to an exemplary embodiment, a package has a component carrier (such as a printed circuit board or an integrated circuit substrate) as well as an optical chip and a cooperating electric chip being embedded in the component carrier laterally with respect to each other. Advantageously, a signal path (which may be an electric signal path and/or an optical signal path) for transporting signals between the optical chip and the electric chip may be defined horizontally, in particular purely horizontally. By taking this measure, a package with electro-optical functionality may be manufactured with compact design and very short signal paths. This may promote, in turn, signal integrity by strongly suppressing signal loss and signal distortion. Consequently, high signal quality may be ensured. At the same time, the small signal losses may also lead to small heat dissipation of the chips into the component carrier, thereby promoting a high thermal performance and suppressing thermal stress. Reduced thermal stress may, in turn, keep undesired phenomena such as warpage and delamination small. To put it shortly, transmission lines of a package with embedded optical and electrical chips may be significantly shortened according to exemplary embodiments. As a result, a highly compact package with electro-optical functionality and high electric reliability, mechanical reliability and thermal performance may be obtained.

### Detailed Description of Exemplary Embodiments

In the following, further exemplary embodiments of the package and the method will be explained.

In an embodiment, the optical chip and the electric chip are embedded side-by-side in a surface region of the component carrier. Consequently, the optical chip and the electric chip may extend almost up to an upper main surface of the package and may be coupled for signal exchange between them by a planar redistribution layer or structure on the top side of the package. Such a package is simple to manufacture, and also allows for very short signal paths between electric chip and optical chip, and also with at least one optional surface mounted chip (such as the below described control chip).

In an embodiment, the optical chip and the electric chip are integrated in a packaging body being embedded in the component carrier. Such embodiments will be explained in the following. However, it is also possible that the optical chip and the electric chip are directly embedded separately in the component carrier. For instance, the optical chip and the electric chip may be inserted in one or two cavities or recesses of the component carrier and may then be glued in place, for instance by lamination.

In an embodiment, the optical chip and the electric chip are integrated in a packaging body being embedded in the component carrier. The packaging body may comprise at least one dielectric layer.

In an embodiment, the optical chip and the electric chip are encapsulated in a packaging material being embedded in the component carrier. Such an integral body of packaging material, optical chip and electric chip may be embodied as a whole in the component carrier, for instance in a cavity therein. The packaging material may comprise laminate material.

An advantage of laminate material of the packaging body is that the material of the component carrier (in particular comprising resin) may have the same or similar physical properties (for example coefficient of thermal expansion, CTE), which may keep a CTE mismatch and consequently warpage small. However, there is also the possibility of a wafer level package, which may have the advantage that it may allow to achieve a higher density of layers of a redistribution structure.

The described approach of embedding a packaging body in a cavity of a component carrier may lead to a highly efficient manufacturing process.

In an embodiment, the optical chip and the electric chip are integrated in a panel level packaging body being embedded in the component carrier. Panel level packaging may denote a process where a laminate is attached to an integrated circuit or chip before the panel - in which the integrated circuit or chip is embedded - is separated into individual boards. In panel level packaging, a large plurality of chips are embedded in a laminate on panel format. According to the described embodiment, the optical chip and the electric chip may be embedded in a laminate, and a part of the singulated laminate with embedded chips may be embedded as a single panel level packaging body in the component carrier.

In an embodiment, the optical chip and the electric chip are encapsulated in a laminate (such as an organic laminate) being embedded in the component carrier. Such an integral body of laminate, optical chip and electric chip may be embodied as a whole in the component carrier, for instance in a cavity therein. Such an integral body may be a panel level packaging body.

Also the described approach of embedding a panel level packaging body in a cavity of a component carrier may lead to a highly efficient manufacturing process.

In an embodiment, the optical chip and the electric chip are embedded at the same upper vertical level and/or lower vertical level, for example in a surface region of the component carrier. By aligning upper main surfaces and/or lower main surfaces of the optical chip at the electric chip, a horizontal signal transport in between may be further simplified. A skilled person is aware of the fact that unavoidable device tolerances and/or machine tolerances may lead to very small mutual displacements between aligned main surfaces of the chips.

In an embodiment, upper main surfaces of the optical chip and the electric chip are recessed with respect to an upper main surface of the component carrier. A vertical gap corresponding to a vertical recess between upper main surfaces of the component carrier and upper main surfaces of the chips may be filled partially or entirely by at least one redistribution layer or structure for interconnecting the electric chip and the optical chip for signal transmission in between. In particular, a thickness of such a redistribution layer or structure above the chips (and consequently the vertical offset between the upper surface of the optical chip and the electric chip with respect to the component carrier's upper main surface) may be in a range from 10 nm to 500 µm, preferably 50 nm to 50 µm.

In an embodiment, the package comprises an optical waveguide, in particular a polymer fiber (wherein any tunable reflective index material, waveguides in glass, etc. may also be an option), configured for supplying an optical signal to a semiconductor waveguide, in particular a silicon waveguide, an indium phosphide (InP) waveguide or a waveguide comprising photo-polymerizable material, at an upper main surface or at a side surface (in particular for chips where the light is coupled from the edge) of the optical chip. More generally, a tunable refractive index material may be used as waveguide material. In particular, an optical waveguide may denote a physical structure that guides electromagnetic waves in the optical spectrum (such as light). Examples of optical waveguides include optical fiber waveguides, transparent dielectric waveguides made of plastic and glass, liquid light guides, and liquid waveguides. A semiconductor waveguide, however may be a waveguide manufactured in semiconductor technology (in particular in silicon technology or InP-based technology) and may form integral part of the optical chip. Alternatively, the semiconductor waveguide may be attached to the optical chip. Highly advantageously, electromagnetic radiation propagating through an optical waveguide may be coupled into the semiconductor waveguide to thereby provide a highly efficient optical signal transfer to the optical chip.

In an embodiment, the optical waveguide is physically connected (in particular with mutual overlap, in case of evanescent field coupling) with the semiconductor waveguide. By a mutual overlap between (in particular horizontal) sections of the optical waveguide and the semiconductor waveguide, an evanescent field coupling may be established in between, thereby highly efficiently optically coupling the optical waveguide with the optical chip. Descriptively speaking, evanescent wave coupling may describe the coupling of an electromagnetic wave from one waveguide to another by way of a decaying electromagnetic field.

However, there are other possibilities to couple the light to the semiconductor waveguide (such as a silicon waveguide). For instance, the waveguide connector can be edge-coupled (in particular endfire-coupled), grating-coupled, or evanescence field coupled. Such optical coupling architectures are explained, as such, for instance in Hosam Mekawey, Mohamed Elsayed, Yehea Ismail, Mohamed A Swillam, "Optical Interconnects Finally Seeing the Light in Silicon Photonics: Past the Hype", Nanomaterials 2022 Jan 29, 12(3):485. Furthermore, all three mentioned coupling mechanism can use adiabatically tapered waveguides as disclosed, as such, in Gyeongho Son, Seungjun Han, Jongwoo Park, Kyungmok Kwon and Kyoungsik Yu, "High-efficiency broadband light coupling between optical fibers and photonic integrated circuits", October 2018, Nanophotonics 7(12). Summarizing, many different optical coupling mechanisms can be realized according to exemplary embodiments of the invention. These include, but are not limited to, edge coupling, grating coupling, evanescent field coupling, and adiabatic optical coupling by tapering the waveguide (in particular with gradual geometrical changes).

In an embodiment, the semiconductor waveguide's horizontal extension does not extend beyond the horizontal extensions of the optical chip. For instance, the semiconductor waveguide may be flush with an edge or may be in the middle of the optical chip.

In an embodiment, at least part of the optical waveguide extends along an upper main surface of the component carrier and/or along an upper main surface of an inlay, in particular a glass inlay, embedded in a surface region of the component carrier. For instance, the optical waveguide may supply an optical signal provided at a side wall of the package (in particular at an upper end of such a side wall) to a more central portion of the package where the optical chip may be arranged. This may be achieved in an easy way by simply attaching the optical waveguide to an upper main surface of the component carrier or to an inlay which may be specifically configured for promoting low loss optical signal transmission. In particular, a glass inlay has turned out as an excellent solution for this purpose.

In an embodiment, the package comprises a waveguide connector being optically coupled with the optical waveguide, and in particular extending along an upper main surface of the component carrier and/or along an upper main surface of an inlay, in particular a glass inlay, embedded in a surface region of the component carrier. The waveguide connector may be an optical fiber connector. Such an optical fiber connector may be an optical member which joins an optical fiber, and enables quick connection and disconnection. An optical fiber connector may mechanically couple and align a core of fibers so that light can pass.

In an embodiment, the package comprises a waveguide connector being optically directly coupled with a semiconductor waveguide, in particular a silicon waveguide or a waveguide comprising photo-polymerizable material, at an upper main surface of the optical chip. The waveguide connector may at least partially extend along an upper main surface of the component carrier and/or along an upper main surface of an inlay, in particular a glass inlay, embedded in a surface region of the component carrier. Such a waveguide connector may be surface mounted on the component carrier and/or on the above described inlay (preferably glass inlay). By directly contacting the waveguide connector with the semiconductor waveguide, the provision of an optical waveguide may be omitted, which may render the package more compact.

In an embodiment, the optical chip is configured for converting a supplied optical signal into an electric signal, and optionally for pre-processing the electric signal. Hence, the optical chip may transform an optical signal directly into an electric signal, for instance by a photodiode of the optical chip. It is also possible that the optical chip provides signal processing, such as modulation. The optical chip may comprise active and/or passive components, in particular monolithically integrated.

Additionally or alternatively, the optical chip may be configured for converting a supplied electric signal into an optical signal, and optionally for pre-processing the optical signal.

In an embodiment, the electric chip is configured for driving the optical chip and/or for amplifying a signal from the optical chip. When embodied as a driver and/or amplifier for the optical chip, the electric chip may comprise circuitry and/or at least one component which may be used to control the optical chip. The electric chip may be configured for amplifying a signal, in particular an optical signal, received from the optical chip, in particular after conversion into an electric signal. For example, the electric chip may comprise at least one transimpedance amplifier (TIA) for this purpose.

In an embodiment, the package further comprises a control chip receiving an electric signal from the electric chip and configured for further processing the electric signal, in particular for forwarding the electric signal to an electronic periphery. For example, the control chip may forward said electric signal to one or more other nodes, for example a central processing unit (CPU). Such a further node may form part of the package or which may be arranged elsewhere (for instance on a motherboard on which also the package may be mounted).

In an embodiment, the package further comprises a control chip being configured as further optical chip for optical processing.

In an embodiment, the control chip is an application-specific integrated circuit (ASIC). Such an ASIC may be an integrated circuit chip which may be customizable or customized for a particular application-specific use, rather than being intended for a general-purpose use.

In an embodiment, the control chip is surface mounted on the component carrier. The control chip may be the main heat source of the entire package (for instance may have a power of 100 W to 2 kW, for example 1 kW). Hence, surface mounting the control chip rather than embedding it may simplify heat removal from such a control chip.

In an embodiment, the package comprises a heat sink mounted on an exposed surface of the control chip. For instance, such a heat sink may be a body made of a highly thermally conductive material (such as copper or aluminum) for promoting heat transfer from the control chip to the heat sink. Furthermore, the heat sink may be shaped (for instance comprising a plurality of cooling fins) for promoting heat removal to an environment, for instance surrounding air. By attaching a heat sink to an exposed main surface of the control chip, the thermal performance of the package may be further improved. In combination with a further possible heat removal path extending from the mounting surface of the control chip downwardly through the component carrier (compare description below), double-sided cooling may be achieved for the control chip. This may lead to excellent thermal properties of the package.

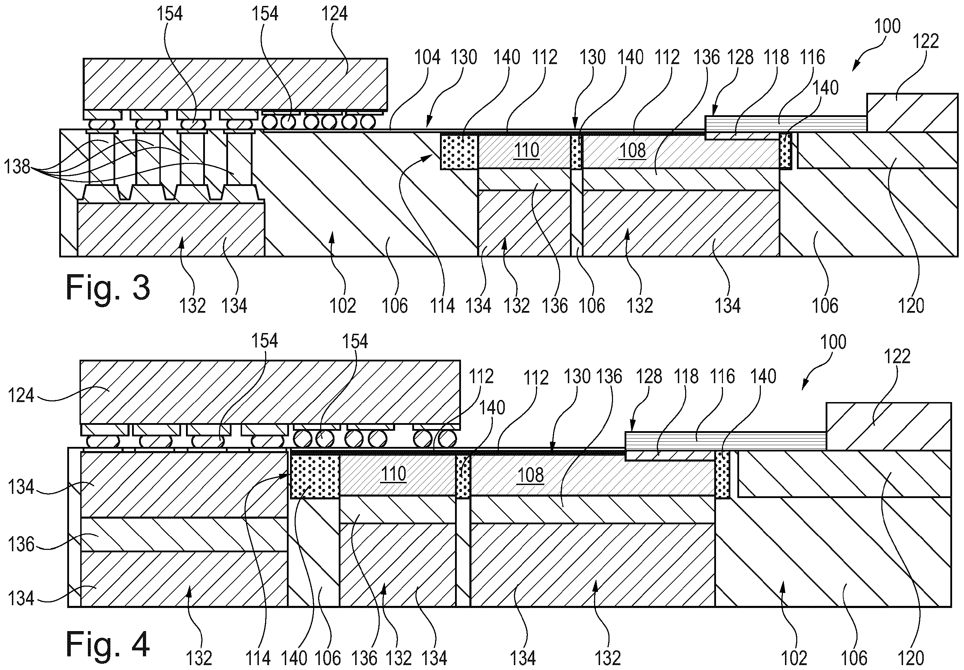

In an embodiment, the control chip is arranged directly above the electric chip (see for example Figure 4). In such a configuration, the signal path from electric chip to control chip is extremely short, which may further promote high signal quality and low thermal losses.

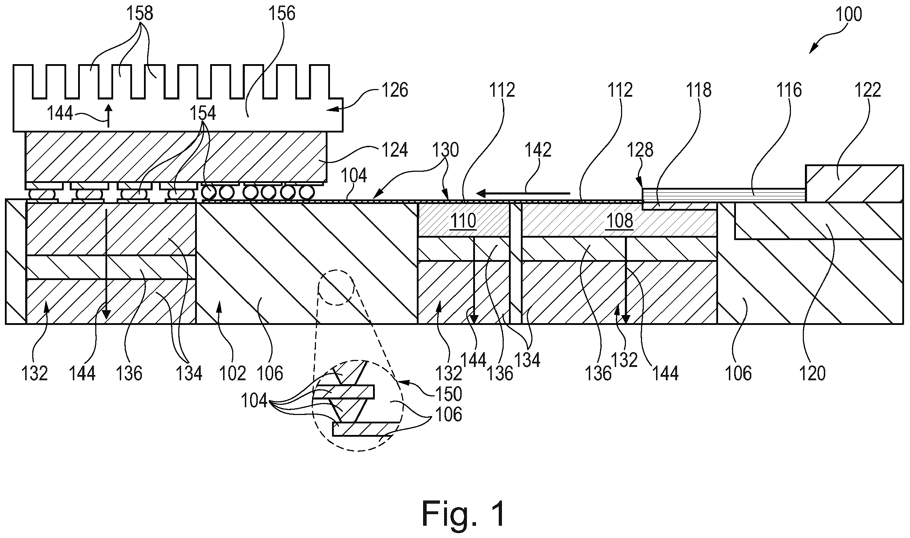

In another embodiment, the control chip is arranged above and laterally displaced with respect to the electric chip. Such an embodiment is shown for instance in Figure 1. A corresponding arrangement may clearly separate the heat removal paths from the control chip on the one hand and the electric chip on the other hand. In particular, an undesired heating of the electric chip by the control chip, or vice versa, may then be reliably prevented.

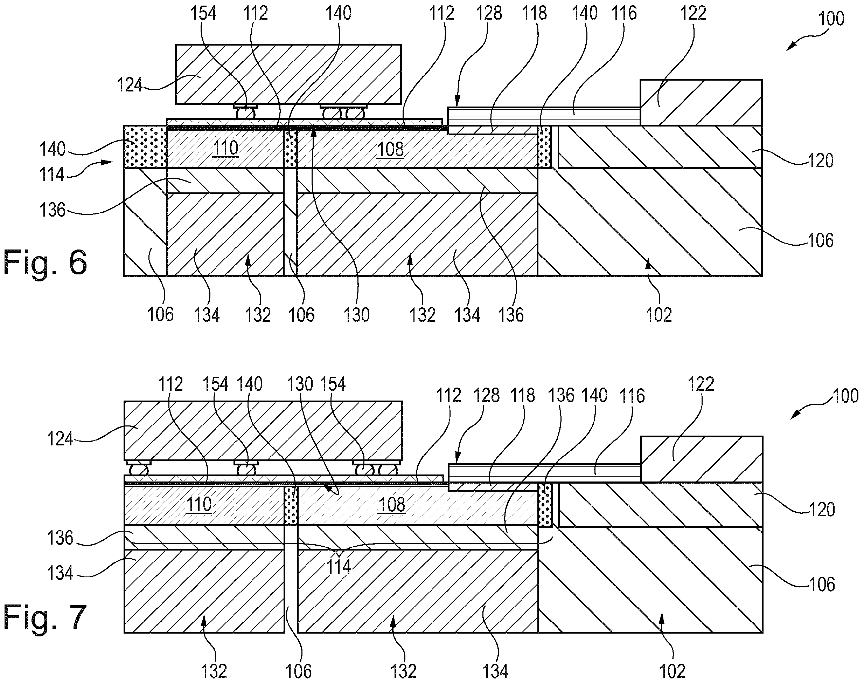

In still another embodiment, the control chip is arranged directly above a packaging body in which the optical chip and the electric chip are integrated (compare for instance Figure 6). Such a design may lead to an extremely compact configuration within a horizontal plane. Also the signal paths between electric chip and/or optical chip on the one hand and control chip on the other hand may be kept extremely short in such a configuration.

In an embodiment, the control chip is arranged directly above a packaging material of a packaging body in which the optical chip and the electric chip are integrated. For such an embodiment, reference is made for instance to Figure 4. In such a configuration, a packaging material may form part of a mounting base for the control chip.

In an embodiment, the package comprises an electric redistribution structure (for example an electric redistribution layer) extending horizontally above the electric chip and/or the optical chip. In the context of the present application, the term "redistribution structure" may particularly denote an arrangement of interconnected patterned electrically conductive structures which have a portion with a lower pitch as compared to another portion with a higher pitch. Pitch may denote a characteristic distance between adjacent electrically conductive elements, such as trace elements and/or connection elements. By providing spatially separate portions of the redistribution structure with different pitch, the redistribution structure may form an electric interface between larger dimensioned electric connection elements and smaller dimensioned electric connection elements. In particular, a number of electrically conductive elements per area may be smaller in a portion with larger pitch (for example larger than 50 µm) than in another portion with smaller pitch (for instance smaller than 50 µm) .

The electric redistribution structure may be a NIL (Nanoimprint Lithography) or PID (Photoimageable Dielectric) patterned structure. In yet another embodiment, a redistribution structure may be made on the basis of silicon, for instance implementing a silicon interposer.

What concerns an NIL-type electric redistribution structure, more generally an electric redistribution structure formed as a design layer with stamped surface profile and metal in indentations of said stamped surface profile may be provided. In the context of the present application, the term "design layer" may denote a layer being flexibly processable for designing substantially any desired surface profile extending therein and/or therethrough. Thus, any desired wiring design may be translated into a corresponding surface profile of the design layer so that filling created indentations in the design layer with electrically conductive material may lead to the predefined wiring design. Preferably, the design layer may be an initially at least partially uncured dielectric which may be cured during and/or after forming a predefined surface profile therein. The surface profile may then be rendered permanent. Hence, the design layer may be deformable before curing and may be non-deformable after curing. Preferably, one or more indentations in the design layer structure may have different horizontal and/or vertical extensions. Alternatively, they may be the same. In the context of the present application, the term "stamping a surface profile in the design layer" may denote the process of imprinting or embossing a predefined surface pattern in the design layer. For instance, this may be accomplished by pressing a working mold (or working stamp) in the (in particular still) deformable design layer or by guiding a working mold along the (in particular still) deformable design layer. Such a working mold may have an inverse surface profile in comparison with the surface profile of the design layer being processed. During a development and manufacturing process, first a master mold may be manufactured, for example by gray scale lithography. Then the master mold may be replicated by stamping several times into a transparent silicone material or the like, and a master working mold may be generated. Finally, working molds may be made by copying the master working mold. The working molds may be used during mass production and imprinted on panel surface. In the context of the present application, the term "stamped surface profile" may denote a surface profile having a characteristic structure resulting from a stamping process executed by pressing a work mold into the design layer. In view of this manufacturing process, the stamped surface profile has a lower roughness, steeper sidewalls and other pattern characteristic than obtainable by etching-based or laser-based patterning processes.

What concerns a PID-type electric redistribution structure, a photoimageable dielectric may denote a dielectric film or layer which can be patterns directly by irradiating a beam of electromagnetic radiation (in particular a laser beam) along a predefined trajectory of the dielectric film or layer to thereby pattern the latter. After such a patterning process, formed recesses in the dielectric film or layer may be filled with an electrically conductive material to thereby obtain the electric redistribution structure.

In an embodiment, at least part of the electric redistribution structure may extend, in particular horizontally and more particularly at a horizontal level corresponding to an upper main surface of the component carrier, so as to be connected to the electric chip. For instance, the electric redistribution structure may be formed as a surface portion of the package at least partially on the optical chip, at least partially on the electric chip, at least partially in between the electric chip and the optical chip, and/or at least partially between the electric chip and the control chip.

In an embodiment, at least part of the electric redistribution structure extends under the control chip. Thus, also a different pitch below the control chip, on the one hand, and below the electric chip, on the other hand, may be bridged by the electric redistribution structure.

In an embodiment, at least part of the electric redistribution structure is provided within the packaging body, in particular within the panel level packaging body. Such a packaging body may comprise, as a single integral body, electric chip, optical chip and an encapsulant (which may be a laminate, in particular an organic laminate, in case of a panel level packaging body). Advantageously, also the electric redistribution structure (or part thereof) may be integrated in the packaging body. This may further simplify the entire manufacturing process of the package.

In an embodiment, a further electric redistribution structure is provided above the electric redistribution structure and electrically connecting the electric chip and/or the optical chip with the component carrier. Thus, also a plurality of interconnected electric redistribution structures may be provided, which may be arranged laterally with respect to each other and/or on top of each other. This may allow to obtain even sophisticated electric interconnections without deviating from a substantially horizontal signal transmission.

In an embodiment, the electric redistribution structure (in particular layer) extends over at least two vertically stacked electrically conductive layer structures. For instance, the electric redistribution structure may extend over 1, 2 or 3 thin layers.

In particular, the package may comprise an optical redistribution structure (for example an optical redistribution layer) extending, more particularly horizontally and more particularly at a horizontal level corresponding to an upper main surface of the component carrier, so as to be connected to the optical chip. The optical redistribution structure may redistribute optical signals with different structural dimensions. For instance, the optical redistribution structure may manage an optical interface between a larger dimensioned optical waveguide and a smaller dimensioned semiconductor waveguide forming part of or being connected to the optical chip.

In an embodiment, the optical redistribution structure and the electric redistribution structure share a common horizontal plane. Preferably, both the optical redistribution structure and the electric redistribution layer may extend along an upper main surface of the package. This may concentrate both optical and electric signal propagation within a common horizontal plane.

In an embodiment, the package comprises a heat removal structure configured for removing heat from the package and extending vertically through the component carrier. More specifically, a respective heat removal structure may remove heat created by the optical chip out of the package, may remove heat created by the electric chip out of the package, and/or may remove heat created by the control chip out of the package. In particular, an assigned heat removal structure may be provided for each individual of said chips. The heat removal structure may be made of a thermally highly conductive material, preferably having a thermal conductivity of at least 50 W/mK. Preferably, the heat removal structure comprises or consists of copper.

In an embodiment, at least part of the heat removal structure extends between a bottom of the optical chip and/or of the electric chip and/or of a control chip on the one hand and a lower main surface of the component carrier on the other hand. Thus, the respective heat removal structure may extend over the entire vertical thickness from the bottom side of the respective chip to the bottom main surface of the package.

In an embodiment, the heat removal structure comprises at least one metal block (such as a copper block) and/or at least one metal paste structure (in particular copper paste) and/or at least one metal pillar (such as a copper pillar or an array of parallel copper pillars). In particular, at least one metal block, at least one metal paste structure and/or at least one metal pillar may be vertically stacked in the respective heat removal structure.

In an embodiment, the package is configured so that a signal flow is horizontal and a heat flow is vertical. In other words, the signal flow and the heat flow may be perpendicular one to each other. By the above-mentioned heat removal structure(s) extending vertically through the package and/or by the above-mentioned heat sink mounted on top of the control chip (and optionally on top of the electric chip and/or optical chip, when accessible at or close to an upper main surface of the package), vertical heat removal may be triggered in an upward and/or downward direction. In contrast to this, electrical and/or optical coupling structures (such as the above-mentioned electric redistribution structure and/or the optical redistribution structure) may promote a horizontal signal flow of electric signals, and optionally also of optical signals. This may reliably decouple signal flow from heat flow.

In an embodiment, the signal path extends within a horizontal plane which corresponds to the upper main surface of the component carrier. Propagating electric and/or optical signals along an upper main surface of the component carrier and/or of the package may lead to a simple construction of the package and short signal paths also with respect to a surface mounted control chip.

In an embodiment, an optical signal path section and an electric signal path section of the signal path share a common horizontal plane. In particular, the above-mentioned electric redistribution structure and the above-mentioned optical redistribution structure may be at least partially coplanar. Also this contributes to short signal paths.

In an embodiment, an electric signal path section of the signal path for transmitting an electric signal between the optical chip and the electric chip is free of vertical through connections. In particular, no stacked vias may be required for the mentioned electric transmission and no vertical optical fiber sections may be needed for the mentioned optical transmission.

In an embodiment, the component carrier is an integrated circuit substrate. In the context of the present application, the term "integrated circuit substrate" (IC substrate) may particularly denote a component carrier having a size and a pitch adjusted to the requirements of an integrated circuit component (in particular the control chip) mounted thereon. An IC substrate may be a, in relation to a PCB, comparably small component carrier onto which one or more integrated circuit components may be mounted and that may act as a connection body between one or more chip(s) and a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). A pitch, i.e. a distance between corresponding edges of two adjacent metal structures, of an IC substrate may be not more than 150 µm, in particular not more than 100 µm. In contrast to this, a pitch of a PCB may be at least 200 µm, in particular at least 300 µm.

In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

The aspects defined above and further aspects of the invention are apparent from the examples of embodiment to be described hereinafter and are explained with reference to these examples of embodiment.
Figure 1 illustrates a cross-sectional view of a package according to an exemplary embodiment of the invention.
Figure 2A illustrates a cross-sectional view of a package according to another exemplary embodiment of the invention.
Figure 2B illustrates a cross-sectional view of a packaging body for embedding in a component carrier of the package according to Figure 2A.
Figure 3 illustrates a cross-sectional view of a package according to another exemplary embodiment of the invention.
Figure 4 illustrates a cross-sectional view of a package according to another exemplary embodiment of the invention.
Figure 5 illustrates a cross-sectional view of a package according to another exemplary embodiment of the invention.
Figure 6 illustrates a cross-sectional view of a package according to another exemplary embodiment of the invention.
Figure 7 illustrates a cross-sectional view of a package according to another exemplary embodiment of the invention.
Figure 8 to Figure 13 illustrate cross-sectional views of portions of packages according to exemplary embodiments of the invention with different optic coupling structures.
Figure 14 illustrates a cross-sectional view of a portion of a package according to another exemplary embodiment of the invention with different coupling between an electric chip and a corresponding electric redistribution structure.
Figure 15 illustrates a cross-sectional view of a package according to another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

Conventional optical transceivers may be front panel pluggable modules. There may be - with increasing signal speed - a need to shorten the electric transmission line length in such a module or package.

According to an exemplary embodiment of the invention, a package comprises a component carrier (such as an integrated circuit substrate) in which an optical chip (such as a photonic integrated circuit) and an assigned electric chip (in particular an electric drive integrated circuit and/or a transimpedance amplifier circuit) may be embedded juxtaposed in a lateral direction. Advantageously, a signal path (in particular an electric signal path, optionally also an optical signal path) between the optical chip and the electric chip may extend within a horizontal plane. This may shorten the - in particular electric - transmission line length. Consequently, small signal losses may lead to a high signal quality and limited heat removal complexity.

In particular, a package according to an exemplary embodiment may provide an embedded fan-out package which may be integrated by a fan-out panel level package (FOPLP) approach for photonic integrated circuit applications. Further advantageously, a (for example sputtered) redistribution structure (in particular one or more redistribution layers) may be formed for connecting the package body with a (in particular ASIC-type) control chip.

The above-described embodiments have advantages: In particular, the described manufacturing architecture may allow to separate a signal path (in a horizontal plane) from a thermal path (in a vertical direction). The above-mentioned package may include both an electric chip and an optical chip (also denoted as photonic IC) which may ensure highest performance and smallest form factor. Furthermore, a very short electrical signal path may be achieved without the need to create vertical interconnection elements or through silicon vias (TSV). With the described package architecture, it may also be possible to obtain an advantageous (in particular optimized) die operation temperature. In particular, double sided cooling of an ASIC-type control chip may be achieved. The described package design also allows a tailored heat removal architecture (in particular between electric chip and optical chip). Apart from this, it may be possible to separate an optical and an electrical interface alignment. Furthermore, improved optical alignment tolerances may be achieved through an evanescent field coupling, thereby avoiding the need of an active alignment of the package. Advantageously, an optical inspection of an optical interface may be possible (since an optical waveguide may be aligned on top of a semiconductor waveguide and the optical chip). It may also be possible to integrate shielding elements (in particular for shielding electromagnetic radiation, more particularly radio frequency radiation) and/or magnetic elements (for shielding purposes or for providing a magnetic application) in the package.

Exemplary applications of exemplary embodiments of the invention are co-packaged optics and silicon photonics in data communication and telecommunication applications. For instance, this may allow to package switches and transceivers for integration in data centers and 5G radio access networks. Furthermore, packages according to exemplary embodiments of the invention may be used for automotive applications like lidar and/or radar. More generally, packages according to exemplary embodiments of the invention may be used for high speed and/or high data rate applications, for instance in data centers. Moreover, one package technology may be provided for multiple applications, for instance in terms of data communication and telecommunication. For example, packages according to exemplary embodiments may be used for manufacturing transceivers, switches, network interfacing cards in data centers and 5G radio access networks.

More specifically, a package according to an exemplary embodiment of the invention may be used for forming a switch (for example an ethernet switch or a fiber-optic network switch) or a transceiver (for instance for converting between an optical signal and an electric signal, once or multiple times). An ethernet switch may connect a plurality of optical fibers and may control routing. A photonic switch may be achieved by selectively switching an optical signal supplied by an optical fiber or an optical IC. A photonic switch may route an optical signal between an optical input and an optical output without conversion or signal manipulation. An optical transceiver or optical module may have an electrical interface on the side that connects to the inside of the system and an optical interface on the side that connects to the outside world through a fiber-optic cable or a fiber connector.

In particular, the following applications can be fulfilled with packages according to exemplary embodiments of the invention: Photonic IC applications; electro-optical conversion on IC substrate level; electro-optical IC substrates; co-packaged optics and silicon photonics in data communication and telecommunication (in particular packaging of switches and transceivers for integration in data centers and 5G radio access networks); optical communication applications (data communication, telecommunication, 5G radio access networks, radar networks in tower); computing applications like high performance computing (HPC), photonic computing, quantum computing; automotive applications like lidar.

According to an exemplary embodiment of the invention, an integrated circuit substrate packaging technology for photonic integrated circuit applications is provided, in which a fan-out packaging body is integrated by a fan-out panel level packaging body (FOPLP) approach in an IC substrate. An embodiment relates to an IC substrate package with integrated optical and electrical interfaces. For example, an optical redistribution layer for optical interconnections may be realized based on waveguides. An electric redistribution structure may be used for the electric interconnection. Additionally, a package according to an exemplary embodiment of the invention may be designed for the embedding of an packaging body comprising heterogeneous component integration (i.e. integration of optical chip and electric chip). Particularly, an exemplary embodiment provides an integrated circuit substrate with embedded packaging body, wherein the optical chip and the electric chip may be co-packaged in a single package. A thermal path between the packaging body, the substrate and the environment may be realized on IC substrate level. Integration of a packaging body may allow for manufacturing a short signal path (in form of the electric redistribution structure) between the packaging body and an application-specific integrated circuit or control chip. Hence, exemplary embodiments provide an efficient optical interface (in particular in form of an optical redistribution layer based on a tunable refractive index material, for instance embodied as polymer waveguides) and a thermal management solution integrated in an IC substrate package.

In embodiments, the packaging body may be embedded in the IC substrate by forming a cavity in a core and inserting the packaging body in the cavity after having closed the bottom of the cavity by a temporary carrier. After gluing and/or laminating the packaging body in place, the temporary carrier may be moved, and a subsequent build-up may be formed on the bottom side and/or on the top side. In particular, this may lead to a design in which the package surface and the substrate surface may be on the same height level (which may be denoted as flash mounted package). After embedding of the packaging body, an electrical redistribution structure may be realized partly on the surface of the packaging body and partly on the surface of the substrate. Such an electrical redistribution structure may be formed by thin-film technology such as sputtering or thick-film technology such as plating. The electrical redistribution structure may thereby connect to the packaging body with an ASIC-type control chip, which may be surface mounted on the substrate. Highly advantageously, a very short signal path (preferably showing no cross-sectional variations) can be realized with such a design. The optical redistribution layer may be realized by embedding one or more glass inlays. Such an optical interface may allow for an optical signal coupling between a fiber connector and a semiconductor waveguide (in particular a silicon waveguide). The polymer waveguide may be located on top of the glass inlay, whereas the semiconductor waveguide may be implemented on a surface of the optical chip. An optical signal may be transmitted from the fiber connector through the polymer waveguide to the semiconductor waveguide by using evanescent field coupling.

Such a manufacturing architecture may enable to obtain a high optical alignment precision, thereby facilitating high-volume manufacturing. Additionally, a thermal path may be established from the control chip through the substrate, towards an environment of the package. Heat removal structures may be integrated in the integrated circuit substrate. Thereby, thermally conductive materials (such as copper coins, or any other thermally conductive blocks and paste) may be embedded within the body of the integrated circuit substrate. As the control chip is surface mounted, this design may allow for double-sided cooling of the control chip, which may be a main heat source of the entire package. Moreover, such a design may offer manufacturing of preferential thermal paths to reduce or even minimize thermal resistance between the optical chip and the electric chip. Thereby, an exemplary embodiment may provide the possibility to separate the thermal path from the electrical path, thereby ensuring proper operation temperature.

Other manufacturing processes are of course possible as well for embedding the packaging body.

**Figure 1** illustrates a cross-sectional view of a package 100 according to an exemplary embodiment of the invention.

Figure 1 illustrates package 100 which comprises a component carrier 102. Component carrier 102 may be an integrated circuit (IC) substrate. The component carrier 102 may comprise a laminated layer stack comprising electrically conductive layer structures 104 and electrically insulating layer structures 106. As indicated by a detail 150, the electrically conductive layer structures 104 may comprise patterned metal layers (such as patterned copper foils or patterned deposited copper layers) and vertical through connections, for example copper filled vias, which may be created by drilling and plating. The electrically insulating layer structures 106 may comprise a respective resin (such as a respective epoxy resin), preferably comprising reinforcing particles therein (for instance glass fibers or glass spheres). For instance, the electrically insulating layer structures 106 may be made of FR4. The electrically insulating layer structures 106 may also comprise resin layers being free of glass (fibers).

Furthermore, Figure 1 illustrates an optical chip 108, which may be a photonic IC. The optical chip 108 may convert an optical signal into an electric signal and may process or pre-process the latter. Furthermore, an electric chip 110 is provided which is functionally coupled with the optical chip 108. More specifically, the electric chip 110 may drive or amplify the optical chip 108. Both the electric chip 110 and the optical chip 108 may be manufactured in semiconductor technology, in particular InP technology or silicon technology, for instance as silicon dies. As shown, the electric chip 110 and the optical chip 108 are embedded side-by-side in a surface region of the component carrier 102. Consequently, a signal path 112 between the optical chip 108 and the electric chip 110 extends within a horizontal plane. As shown in Figure 1, both the optical chip 108 and the electric chip 110 are embedded in the component carrier 102. For instance, both the optical chip 108 and the electric chip 110 may be inserted into a common cavity in an upper main surface of the component carrier 102. Alternatively, the optical chip 108 may be inserted in a first cavity in an upper main surface of the component carrier 102 and the electric chip 110 may be inserted into a second cavity in an upper main surface of the component carrier 102.

The optical chip 108 and the electric chip 110 are embedded at the same upper vertical level in the surface region of the component carrier 102. Furthermore, the optical chip 108 and the electric chip 110 are embedded at the same lower vertical level in the surface region of the component carrier 102. They are laterally spaced from each other by a portion of the component carrier 102. As shown, the electric redistribution structure 130 extends also partially under a control chip 124. As shown as well, the electric redistribution structure 130 extends from the optical chip 108, over the electric chip 110 up to the control chip 124. This ensures a direct fan out of the electric signals within the horizontal plane.

Now referring to the supply and processing (for instance modulating) of an optical signal at the package 100, said package 100 comprises an optical waveguide 116, which may be a tunable refractive index material (for example a polymer fiber). The optical waveguide 116 may be configured for supplying an optical signal to the semiconductor waveguide 118 provided at the upper main surface of the optical chip 108. As shown, the optical waveguide 116 extends horizontally along part of the optical chip 108, part of an upper main surface of the component carrier 102 and part of an upper main surface of an inlay 120. Inlay 120 is preferably a glass inlay and is embedded in a surface region of the component carrier 102.

On the right-hand side and of the optical waveguide 116, a waveguide connector 122 is provided so as to be optically coupled with the optical waveguide 116. Also the waveguide connector 122 extends horizontally and is arranged on the upper main surface of the inlay 120. The waveguide connector 122 may be connected with an optical periphery of the package 100 so as to receive an optical signal. Said optical signal is coupled by the waveguide connector 122 into the optical waveguide 116 and from there into the semiconductor waveguide 118. Hence, the optical waveguide 116 and the semiconductor waveguide 118 together form optical redistribution structure 128 which extends horizontally so as to optically connect the waveguide connector 122 to the optical chip 108.

As shown in Figure 1, the optical redistribution structure 128 and the electric redistribution structure 130 share a common horizontal plane. The height (in vertical direction) of the optical redistribution structure 128 may be different from the electric redistribution structure 130 (in this case the optical redistribution structure 128 may be thicker than the electric redistribution structure 130). Alternatively, the height of the optical redistribution structure 128 and the height of the electric redistribution structure 130 may be the same. In the shown embodiment, said common horizontal plane corresponds to a height level of the electric redistribution structure 130 at which also part of the optical redistribution structure 128 is formed. Consequently, optical signals and electric signals are processed within said common horizontal plane. This has a positive impact on signal integrity and may lead to a low optical and electrical signal loss.

When coupled into the semiconductor waveguide 118, the optical signal may be processed by the optical chip 108. Said processing may comprise a conversion of the optical signal into an electric signal by an optoelectrical converter of the optical chip 108, such as a photodiode, and vice versa. While a receiver function is described here (i.e. the optical signal is converted in an electric signal by a photodiode), also an electric signal may be converted to an optical signal using a laser diode (in a transmitter configuration). Thereafter, the optical chip 108 may further process the electric signal, if desired or required. The optical chip 108 may then forward the electric signal to the electric chip 110 and/or to a control chip 124. Preferably, the electric chip 110 is coupled with the optical chip 108 for driving or amplifying the latter, whereas the control chip 124 may further process the electric signal and/or may forward it to another electronic entity (such as a CPU, not shown).

The control chip 124, which may be an ASIC, may be surface mounted on the component carrier 102. As shown in Figure 1, the control chip 124 is arranged above and laterally displaced with respect to the electric chip 110. By a metallic connection structure 154 (such as solder balls) at the bottom side of the control chip 124, the control chip 124 may be electrically coupled to the electric redistribution structure 130 and may be thermally coupled to a below described heat removal structure 132. Since the control chip 124 may be the main heat source of the entire package 100, a heat sink 126 may be mounted on an exposed upper main surface of the control chip 124. A metallic plate 156 of the heat sink 126 may be attached to the control chip 124, whereas cooling fins 158 may dissipate heat flowing from the control chip 124 to the metallic plate 156 towards the environment.

Now referring to the vertically extending heat removal structures 132 of Figure 1, each of them is configured for removing heat from a respective one of the chips 108, 110, 124 of the package 100 towards a bottom side. A first heat removal structure 132 extends from a bottom of the optical chip 108 up to a bottom main surface of the package 100. A second heat removal structure 132 extends from a bottom of the electric chip 110 up to a bottom main surface of the package 100. A third heat removal structure 132 extends from a bottom of the control chip 124 up to a bottom main surface of the package 100. Each of the first and the second heat removal structure 132 comprises a metal paste structure 136 (for instance copper paste) attached to the respective chip 108, 110 and comprises a metal block 134 (for instance a copper block) attached to the respective metal paste structure 136. The third heat removal structure 132 comprises a metal paste structure 136 (for instance copper paste) between two metal blocks 134 (for instance copper blocks).

As a result of the described configuration, an electric and optical signal flow 142 is horizontal and a heat flow 144 is vertical. A signal feeding path extends in a horizontal plane. Heat removal away from chips 108, 110 occurs downwardly, whereas heat removal from the main heat source, i.e. control chip 124, occurs upwardly and downwardly in a double-sided cooling approach. This architecture ensures simultaneously short signal paths and a highly advantageous thermal management.

Although not shown, an electro-magnetic shielding structure and/or one or more barrier layers may be implemented in all embodiments of the package 100 as well. Although not shown, portions of the surface areas may be provided with surface finishes, for example solder resist, ENIPIG.

Advantages of the illustrated package 100 are a separation of the signal path (within a horizontal plane) and a thermal path (in vertical direction). A very short electrical signal path can be obtained without vertical interconnections. Moreover, a proper die operation temperature may be obtained, for which double side cooling of the ASIC is a highly advantageous measure. More generally, a tailored heat removal may be achieved, in particular between the electric chip 110 and the optical chip 108. Furthermore, a separation of optical and electrical interface alignment is advantageous as well. Improved optical alignment tolerances may be achieved, in particular through evanescent field coupling between the optical waveguide 116 and the semiconductor waveguide 118 (this may avoid the need of an active alignment of the packaging body). Furthermore, an optical inspection of the optical interface may be possible, since the optical waveguide 116 is aligned on top of the semiconductor waveguide 118 of the optical chip 108.

Hence, Figure 1 illustrates an IC substrate-type package 100 comprising the IC substrate 102 with embedded optical chip 108 and electric chip 110. Furthermore, a surface mounted ASIC-type control chip 124 is provided. Electric redistribution structure 130 interconnects the optical chip 108 with the electric chip 110 in a direct fan-out architecture. Copper structures are provided for heat dissipation in heat removal structures 132. Glass inlay 120 advantageously carries optical supply components and may provide a mechanical interface for a waveguide connector 122.

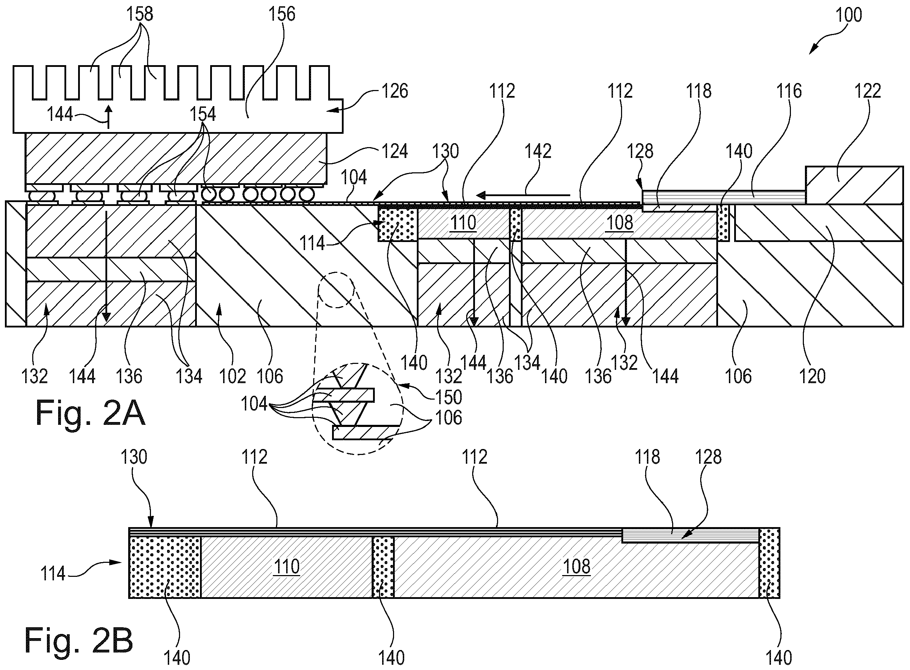

**Figure 2A** illustrates a cross-sectional view of a package 100 according to an exemplary embodiment of the invention. **Figure 2B** illustrates a cross-sectional view of a packaging body 114 for embedding in a component carrier 102 of the package 100 according to Figure 2A.

The embodiment of Figure 2A and Figure 2B differs from the embodiment of Figure 1 in particular in that, according to Figure 2A and Figure 2B, the optical chip 108 and the electric chip 110 are integrated in a packaging body 114. Said packaging body 114 is embedded as a whole in the component carrier 102. As shown, the optical chip 108 and the electric chip 110 are encapsulated in a packaging material 140 of the packaging body 114. Figure 2B shows as well that at least part of an electric redistribution structure 130 (which may be embodied as a planar redistribution layer) is integrated in the packaging body 114 as well, more specifically at an upper main surface thereof. Beyond this, at least part of an optical redistribution structure 128 may be integrated in the packaging body 114 as well, more specifically at the same main surface thereof. In the shown embodiment, the portion of the optical redistribution structure 128 which is integrated in the packaging body 114 comprises a semiconductor waveguide 118. The semiconductor waveguide 118 may be integrally formed with the optical chip 108, or may be formed thereon. The entire packaging body 114 may be embedded in a cavity or hole formed in the integrated circuit substrate 102, or a preform thereof. Hence, embedding the packaging body 114 in the integrated circuit substrate 102 may provide an electric functionality, an optical functionality and both an electric and an optical redistribution functionality to the package 100.

While a lower part of the layered electric redistribution structure 130 is formed as part of the packaging body 114 (see Figure 2B), an upper part of the layered electric redistribution structure 130 is formed partially on its lower part and partially on the component carrier 102, see Figure 2A.

As shown in Figure 2A, the electric redistribution structure 130 extends horizontally above the electric chip 110 and the optical chip 108. In view of its two portions, one forming part of the packaging body 114 and the other one being formed thereon, the electric redistribution structure 130 extends over more than one vertically stacked electrically conductive layer structures.

As shown, the optical waveguide 116 extends horizontally along part of the packaging body 114, part of an upper main surface of the component carrier 102 and part of an upper main surface of an inlay 120.

The fan out packaging body 114 including both the electric chip 110 and the optical chip 108 may ensure a high performance and a small form factor.

**Figure 3** illustrates a cross-sectional view of a package 100 according to another exemplary embodiment of the invention.

The embodiment of Figure 3 differs from the embodiment of Figure 2A and Figure 2B in particular in that, according to Figure 3, the heat removal structure 132 below control chip 124 comprises a metal block 134 below an array of parallel metal pillars 138 (such as copper pillars).

**Figure 4** illustrates a cross-sectional view of a package 100 according to another exemplary embodiment of the invention.

The embodiment of Figure 4 differs from the embodiment of Figure 2A and Figure 2B in particular in that, according to Figure 4, the control chip 124 is arranged directly above the electric chip 110. More specifically, packaging body 114 may be shifted towards the left-hand side according to Figure 4 in comparison with Figure 1 so that also part of packaging material 140 is directly beneath control chip 124. This design allows to manufacture package 100 even more compact in a horizontal direction. Furthermore, this design makes it possible to form the entire electric redistribution structure 130 as part of the packaging body 114.

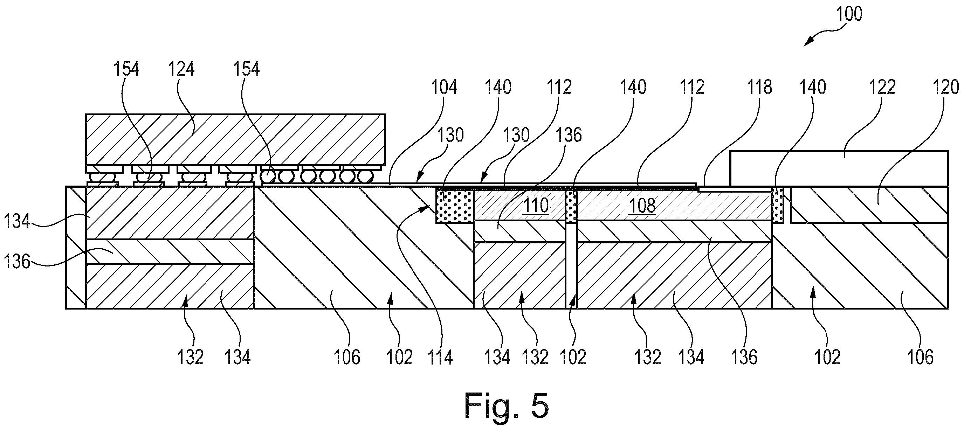

**Figure 5** illustrates a cross-sectional view of a package 100 according to another exemplary embodiment of the invention.

The embodiment of Figure 5 differs from the embodiment of Figure 2A and Figure 2B in particular in that, according to Figure 5, there is no need for providing an optical waveguide 116. In contrast to this, waveguide connector 122 is directly connected to semiconductor waveguide 118 according to Figure 5. More specifically, package 100 according to Figure 5 comprises waveguide connector 122 being optically directly coupled with semiconductor waveguide 118, such as a silicon waveguide, at an upper main surface of the optical chip 108. As shown, the waveguide connector 122 extends partially along packaging body 114, partially along an upper main surface of the component carrier 102 and partially along an upper main surface of an inlay 120, which may be a glass inlay. However, the waveguide connector 122 may also be placed directly on the optical chip 108, and the optical chip 108 may provide a mechanical interface instead of the glass inlay 120. Inlay 120 is embedded in a surface region of the component carrier 102. To put it shortly, a direct optical interface is established from the fiber or waveguide connector 122 to the optical chip 108.

**Figure 6** illustrates a cross-sectional view of a package 100 according to another exemplary embodiment of the invention.

The embodiment of Figure 6 differs from the embodiment of Figure 2A and Figure 2B in particular in that, according to Figure 6, the control chip 124 is arranged directly above part of the electric chip 110 and is arranged directly above part of the optical chip 108. Hence, according to Figure 6, the entire control chip 124 is arranged directly above packaging body 114 in which the optical chip 108 and the electric chip 110 are integrated. More specifically, packaging body 114 may be shifted towards the left-hand side according to Figure 6 in comparison with Figure 1 so that also part of packaging material 140 is directly beneath control chip 124. This design allows to a manufacture package 100 even more compact within a horizontal plane. Furthermore, this design makes it possible to form the entire electric redistribution structure 130 as part of the packaging body 114.

According to Figure 6, the horizontal or planar extension of the control chip 124 is less than the horizontal or planar extension of the packaging material 140 of the packaging body 114. In this context, the term horizontal or planar extension may relate to a respective extension in the horizontal plane, i.e. in a plane perpendicular to the vertical direction according to Figure 6. One further difference is that in Figure 2A and Figure 2B the metallic connection structure 154 has different vertical extensions. For example bigger ones for better heat dissipation, and smaller ones for a more reliable signal transfer from the control chip 124 to the electric redistribution structure 130.

**Figure 7** illustrates a cross-sectional view of a package 100 according to another exemplary embodiment of the invention.

The embodiment of Figure 7 differs from the embodiment of Figure 6 in particular in that, according to Figure 7, the packaging body 114 is a panel level packaging body. Hence, according to Figure 7, the optical chip 108 and the electric chip 110 are encapsulated in an organic laminate (for instance a PCB laminate or an IC substrate laminate) being embedded in the component carrier 102. The optical chip 108, the electric chip 110 and the electric redistribution structure 130 (or part thereof) may be integrated within panel level packaging body. The panel level packaging body uses an organic laminate-type encapsulant.

Furthermore, according to Figure 7, the external profile of the control chip 124 is partially flush with the external profile of the panel level packaging body (i.e. on the left-hand side according to Figure 7).

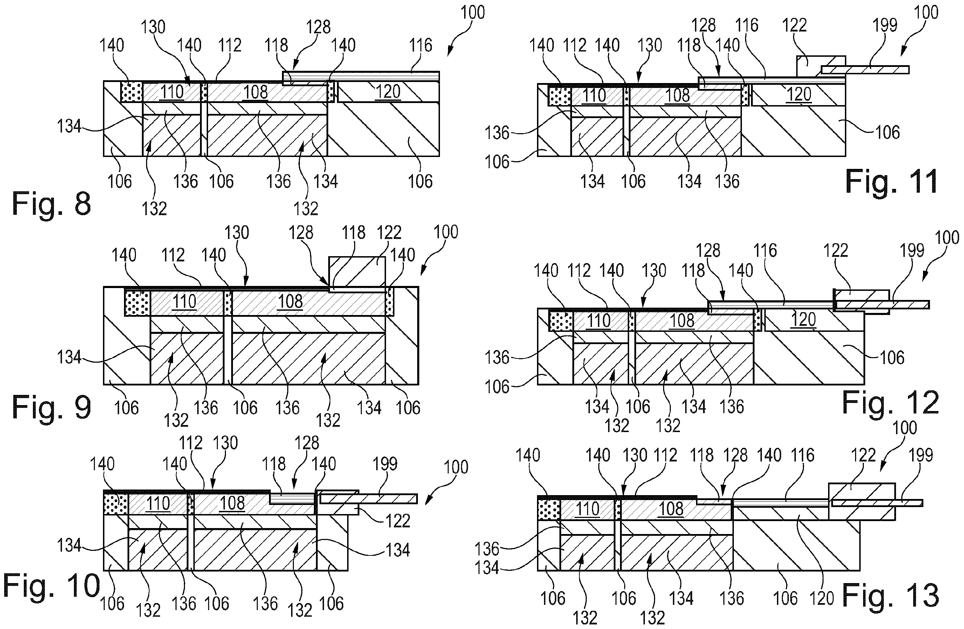

Figure 8 to Figure 13 illustrate cross-sectional views of portions of packages 100 according to exemplary embodiments of the invention with different optic coupling structures.

According to Figure 8 to Figure 10, an optical coupling architecture with one optical interface is shown. An optical waveguide 116 (which may be in particular polymer or glass based) or a waveguide connector 122 may be provided.

Referring to **Figure 8**, an optical waveguide 116 is optically connected with a semiconductor waveguide 118 with a connection area being in a horizontal plane.

Referring to **Figure 9**, a waveguide connector 122 is optically connected with a semiconductor waveguide 118 with a connection area being in a horizontal plane.

Referring to **Figure 10**, a waveguide connector 122 is optically connected with a semiconductor waveguide 118 with a connection area being in a vertical plane. Moreover, an optical fiber 199 is optically connected with the waveguide connector 122.

According to Figure 11 to Figure 13, an optical coupling architecture with two optical interfaces is shown. An optical waveguide 116 (which may be in particular polymer or glass based) and a waveguide connector 122 may be provided.

Referring to **Figure 11**, a waveguide connector 122 is optically connected with an optical waveguide 116 which is optically connected, in turn, with a semiconductor waveguide 118 with connection areas being in a horizontal plane. Moreover, an optical fiber 199 is optically connected with the waveguide connector 122.

Referring to **Figure 12**, a waveguide connector 122 is optically connected with an optical waveguide 116 with a connection area being in a vertical plane. The optical waveguide 116 is optically connected, in turn, with a semiconductor waveguide 118 with a connection area being in a horizontal plane. Moreover, an optical fiber 199 is optically connected with the waveguide connector 122.

Referring to **Figure 13**, a waveguide connector 122 is optically connected with an optical waveguide 116 which is optically connected, in turn, with a semiconductor waveguide 118 with connection areas being in a vertical plane. Moreover, an optical fiber 199 is optically connected with the waveguide connector 122.

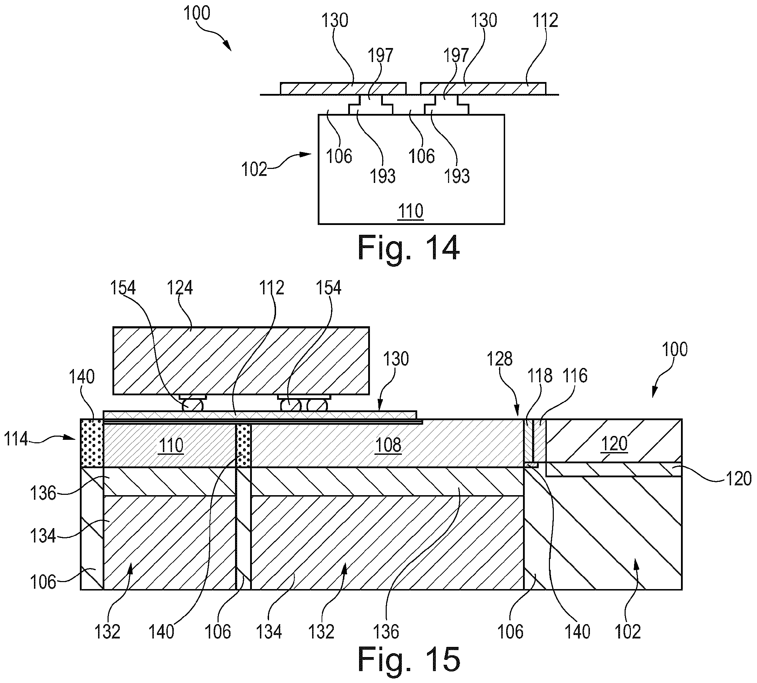

**Figure 14** illustrates a cross-sectional view of a portion of a package 100 according to another exemplary embodiment of the invention with a different coupling architecture between an electric chip 110 and a corresponding electric redistribution structure 130.

According to Figure 14, one or more pads 193 on a main surface of the electric chip 110 (wherein a corresponding coupling can be established also with the optical chip 108 and/or the control chip 124) are provided or are integrally formed with protruding bumps 197. Said protruding bumps 197 may be metallic posts or pillars. The protruding bumps 197 may be embedded in dielectric material, for instance a dielectric laminate, which may form part of the component carrier 102. By exposing the protruding bumps 197, they can be directly connected with an electric redistribution structure 130 with low effort.

**Figure 15** illustrates a cross-sectional view of a package 100 according to another exemplary embodiment of the invention.

According to Figure 15, the optical redistribution structure 128 comprises semiconductor waveguide 118 and optical waveguide 116 being laterally attached to the optical chip 108. Such a lateral optical coupling may be accomplished over the full height of the optical chip 108 or only part. Also Figure 15 shows two optical interfaces.

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. A package (100), wherein the package (100) comprises:
a component carrier (102) comprising at least one electrically conductive layer structure (104) and/or at least one electrically insulating layer structure (106); and
an optical chip (108) and an electric chip (110) being functionally coupled with each other and being embedded side-by-side in the component carrier (102) so that a signal path (112) between the optical chip (108) and the electric chip (110) is within a horizontal plane.

2. The package (100) according to claim 1, comprising at least one of the following features:
wherein the optical chip (108) and the electric chip (110) are integrated in a packaging body (114) being embedded in the component carrier (102),
wherein in particular the packaging body (114) is a panel level packaging body, and wherein the optical chip (108) and the electric chip (110) are encapsulated in a laminate being embedded in the component carrier (102);
wherein the optical chip (108) and the electric chip (110) are embedded at the same upper vertical level and/or at the same lower vertical level, in particular in a surface region of the component carrier (102);
wherein upper main surfaces of the optical chip (108) and the electric chip (110) are recessed with respect to an upper main surface of the component carrier (102).

3. The package (100) according to any of claims 1 to 2, comprising an optical waveguide (116), in particular a polymer fiber, configured for supplying an optical signal to a semiconductor waveguide (118), in particular a silicon waveguide, an indium phosphide waveguide or a waveguide comprising photo-polymerizable material, at an upper main surface or at a side surface of the optical chip (108).

4. The package (100) according to claim 3, comprising at least one of the following features:
wherein the optical waveguide (116) is physically connected with the semiconductor waveguide (118);
wherein at least part of the optical waveguide (116) extends along an upper main surface of the component carrier (102) and/or along an upper main surface of an inlay (120), in particular a glass inlay, embedded in a surface region of the component carrier (102);
comprising a waveguide connector (122) being optically coupled with the optical waveguide (116), and in particular extending along an upper main surface of the component carrier (102) and/or along an upper main surface of an inlay (120), in particular a glass inlay, embedded in a surface region of the component carrier (102).

5. The package (100) according to any of claims 1 to 2, comprising a waveguide connector (122) being optically directly coupled with a semiconductor waveguide (118), in particular a silicon waveguide or a waveguide comprising photo-polymerizable material, at an upper main surface of the optical chip (108), wherein the waveguide connector (122) in particular at least partially extends along an upper main surface of the component carrier (102) and/or along an upper main surface of an inlay (120), in particular a glass inlay, embedded in a surface region of the component carrier (102).

6. The package (100) according to any of claims 1 to 5, comprising at least one of the following features:
wherein the optical chip (108) is configured for converting a supplied optical signal into an electric signal and/or for converting a supplied electric signal into an optical signal, and optionally for pre-processing the electric signal and/or the optical signal;
wherein the electric chip (110) is configured for driving the optical chip (108) and/or for amplifying a signal received from the optical chip (108), in particular after conversion into an electric signal.

7. The package (100) according to any of claims 1 to 6, comprising one of the following features:
further comprising a control chip (124) receiving an electric signal from the electric chip (110) and configured for further processing the electric signal, in particular for forwarding the electric signal to an electronic periphery;
further comprising a control chip (124) being configured as a further optical chip.

8. The package (100) according to claim 7, comprising at least one of the following features:
wherein the control chip (124) is surface mounted on the component carrier (102);
comprising a heat sink (126) mounted on an exposed surface of the control chip (124);
the control chip (124) is arranged directly above the electric chip (110);
the control chip (124) is arranged above and laterally displaced with respect to the electric chip (110);
the control chip (124) is arranged directly above a packaging body (114) in which the optical chip (108) and the electric chip (110) are integrated;
the control chip (124) is arranged directly above a packaging material (140) of a packaging body (114) in which the optical chip (108) and the electric chip (110) are integrated.

9. The package (100) according to any of claims 1 to 8, comprising an optical redistribution structure (128) extending, in particular horizontally and more particularly at a horizontal level corresponding to an upper main surface of the component carrier (102), so as to be connected to the optical chip (108).

10. The package (100) according to any of claims 1 to 9, comprising an electric redistribution structure (130) extending horizontally above the electric chip (110) and/or the optical chip (108).

11. The package (100) according to claim 10, comprising at least one of the following features:
wherein at least part of the electric redistribution structure (130) extends over at least two vertically stacked electrically conductive layer structures;
wherein at least part of the electric redistribution structure (130) extends under a control chip (124);
wherein at least part of the electric redistribution structure (130) is provided within a packaging body (114), in particular within a panel level packaging body;
wherein a further electric redistribution structure is provided above the electric redistribution structure (130) and electrically connecting the electric chip (110) and/or the optical chip (108) with the component carrier (102);
wherein the optical redistribution structure (128) and the electric redistribution structure (130) share a common horizontal plane.

12. The package (100) according to any of claims 1 to 11, comprising a heat removal structure (132) configured for removing heat from the package (100) and extending vertically through the component carrier (102).

13. The package (100) according to claim 12, comprising at least one of the following features:
wherein at least part of the heat removal structure (132) extends between a bottom of the optical chip (108) and/or of the electric chip (110) and/or of a control chip (124) on the one hand and a lower main surface of the component carrier (102) on the other hand;
wherein the heat removal structure (132) comprises at least one metal block (134) and/or at least one metal paste structure (136) and/or at least one metal pillar (138).

14. The package (100) according to any of claims 1 to 13, comprising at least one of the following features:
configured so that a signal flow (142) is horizontal and a heat flow (144) is vertical;
wherein the signal path (112) extends within a horizontal plane which corresponds to the upper main surface of the component carrier (102) or the package (100);
wherein an optical signal path section and an electric signal path section of the signal path (112) share a common horizontal plane;
wherein an electric signal path section of the signal path (112) for transmitting an electric signal between the optical chip (108) and the electric chip (110) is free of vertical through connections;
wherein the component carrier (102) is an integrated circuit substrate.

15. A method of manufacturing a package (100), wherein the method comprises:
providing a component carrier (102) comprising at least one electrically conductive layer structure (104) and/or at least one electrically insulating layer structure (106);
functionally coupling an optical chip (108) and an electric chip (110) with each other; and
embedding the optical chip (108) and the electric chip (110) side-by-side in the component carrier (102) so that a signal path (112) between the optical chip (108) and the electric chip (110) is within a horizontal plane.
